# EUROPEAN PATENT APPLICATION

(11) **EP 1 881 726 A2**
(43) Date of publication of application: **23.01.2008**
(21) Application number: 07112464.8
(22) Date of filing: 13.07.2007
(51) Int. Cl.: H04Q 9/00

(54) **Communication device**

(30) Priority: 21.07.2006 JP 2006199050
(71) Applicant: Sanden Corporation, Isesaki-shi, Gunma 372-8502 (JP)
(72) Inventor: Nakajima, Kazuya, Isesaki-shi, Gunma 372-8502 (JP); Tabata, Masaru, Isesaki-shi, Gunma 372-8502 (JP); Iwazaki, Wataru, Isesaki-shi, Gunma 372-8502 (JP); Ohtsuki, Takahiro, Isesaki-shi, Gunma 372-8502 (JP); Fukamachi, Munenori, Isesaki-shi, Gunma 372-8502 (JP)
(74) Representative: Haley, Stephen

(57) **Abstract**

A communication device includes a case (10) approximately in a shape of box, data circuit-terminating equipment (500) contained in the case (10) for connecting with a radio packet communication network, and a circuit board provided with a circuit for connecting data terminal equipment and the data circuit-terminating equipment (500) each other and mounted with the data circuit-terminating equipment, in which the circuit board includes a main circuit board (300) including a first interface circuit (351) for connecting with data terminal equipment and a circuit (352) for intervening communication between the data terminal equipment and the data circuit-terminating equipment, and an auxiliary circuit board (400) including a second interface circuit (451) for connecting the data circuit-terminating equipment (500) and the main circuit board (300), and the data circuit-terminating equipment (500) is mounted on the auxiliary circuit board (400).

## Description

The present invention relates to a communication device used in a field of telemetring such as collecting sales information in an automatic vending machine or a field of telematics such as distribution of traffic information to a mobile unit, and more specifically to a case structure of the communication device.

Recently, telemetring or telematics for performing collection, distribution and the like of information via a wireless packet communication network has been widespread. The telemetring was originally a collective name of a system for reading out a variable from a meter by using a communication line. Recently, it has expanded its meaning to performance monitoring or remote control of a device as well as reading of data in general. As a typical example of the telemetring, a sales management system for an automatic vending machine, a usage management system for gas and water, and a management system in an unattended car park are known. For an example of the sales management system for an automatic vending machine, see Japanese Patent Publication 2003-51056. The telematics means to provide an information service to a mobile unit such as an automobile on a real-time basis through the combination of a communication system with the mobile unit. As a typical example of the telematics, an on-vehicle information system for providing traffic information or navigation information to a terminal set in an automobile or the like on a real-time basis is known.

In such a field, data circuit-terminating equipment (DCE) for connecting with a wireless packet communication network from a distance and data terminal equipment (DTE), which uses the data circuit-terminating equipment are placed.

For example, in the sales management system in an automatic vending machine, a control device for controlling sales or controlling a temperature in a storage corresponds to data terminal equipment. Each of the data terminal equipment connects with a predetermined network via data circuit-terminating equipment periodically or at an arbitrary time and further connects with a predetermined managing computer via the network. Then, the data terminal equipment connected with the managing computer transmits various types of data to be managed.

There has been a requirement for changing a carrier or a service after constructing such a system. That is partly because an existing carrier can provide neither a stable nor appropriate radio wave at the site where the system is set. Particularly, there has been a requirement for changing a network connecting service for allocating a fixed IP address to a connected terminal to a network connecting service for dynamically allocating an IP address to a connected terminal. The data circuit-terminating equipment needs to be changed to another model for the purpose of satisfying the abovementioned requirements. The data terminal equipment is designed to accommodate only particular data circuit-terminating equipment in most cases. In such a case, it may be impossible to exchange the data circuit-terminating equipment.

A communication device for connecting the data terminal equipment and the data circuit-terminating equipment to intervene their communication has been proposed. The communication device includes data circuit-terminating equipment and a circuit board in the case and operates so that the data terminal equipment identifies that the data circuit-terminating equipment is performing the operation, not the communication device.

When the abovementioned communication device are made to accommodate many types of data circuit-terminating equipment, circuit boards corresponding to respective data circuit-terminating equipment need to be developed and manufactured. That caused a problem of higher costs.

An object of the present invention is to provide a communication device that can easily accommodate various types of communication methods.

For the purpose of achieving the abovementioned object, the application concerned proposes a communication device including a case approximately in a shape of box, data circuit-terminating equipment (DCE) contained in the case for connecting with a radio packet communication network, and a circuit board provided with a circuit for connecting data terminal equipment (DTE) and the data circuit-terminating equipment each other and mounted with the data circuit-terminating equipment, wherein the circuit board includes a main circuit board including a first interface circuit for connecting with data terminal equipment and a circuit for intervening communication between the data terminal equipment and the data circuit-terminating equipment, and an auxiliary circuit board including a second interface circuit for connecting the data circuit-terminating equipment and the main circuit board, and the data circuit-terminating equipment is mounted on the auxiliary circuit board.

According to the present invention, a common circuit independent of each of the data circuit-terminating equipment is formed on the main circuit board and a circuit depending on each of the data circuit-terminating equipment is formed on the auxiliary circuit board. Accordingly, the data circuit-terminating equipment can be easily exchanged.

As an example of specific aspects of the present invention, the application concerned proposes what connects the main circuit board and the auxiliary circuit board by coupling a connector provided on the top surface of the main circuit board to a connector provided on the bottom of the auxiliary circuit board.

According to the present invention, an auxiliary circuit board is arranged above the main circuit board. That can downsize the case of the communication device.

With a board case having a through-hole, through which a coupling part of the connector of the main circuit board and the connector of the auxiliary circuit board can pass, formed on the bottom, and containing the auxiliary circuit board, the auxiliary circuit board can be correctly and easily contained.

With an end of the auxiliary circuit board engaged with an engaging part, which is formed on the board case and the other end screwed into the board case, the auxiliary circuit board can be easily attached to the board case.

With the board case and the main circuit board screwed into the case of the communication device by common screws, inner devices of the communication device such as the main circuit board and the auxiliary circuit board can be easily attached to the case.

With the main circuit board and the board case screwed into the inner surface of a front case using the front case and a rear case of which wider surfaces are superposed on one another as a case of the communication device, the inner devices of the communication device can easily be attached to the case.

Here, as the data circuit-terminating equipment generally has a high heating value, heatsinking is essential in this type of circuit-terminating equipment. Then, the application concerned provides high heatsinking by contacting the data circuit-terminating equipment with the inner surface of the rear case via a heat conductive material.

The other objects, configurations and operations of the present invention will be apparent in the detailed description below

### In the Drawings;

FIG. 1 is a perspective diagram of a communication device;
FIG. 2 is an exploded perspective view of the communication device;
FIG. 3 is an exploded perspective view showing a configuration of an inner device contained in a case; and
FIG. 4 is a functional block diagram of the communication device.

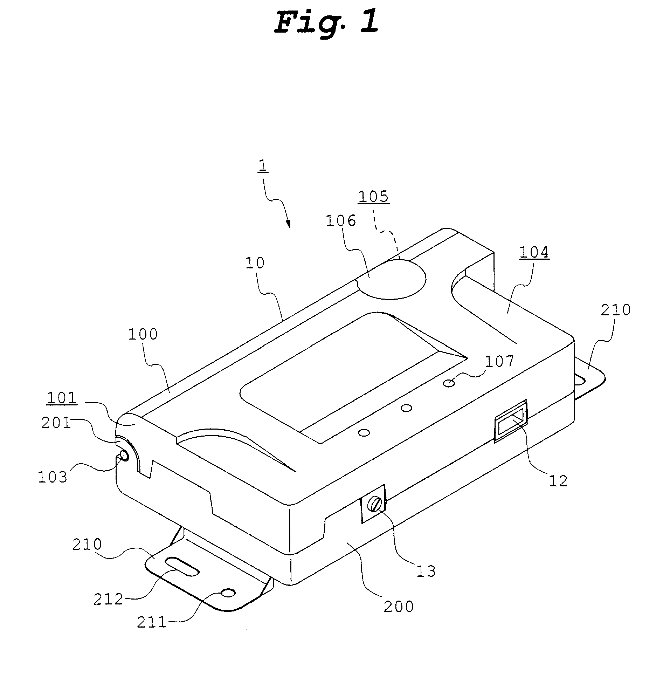

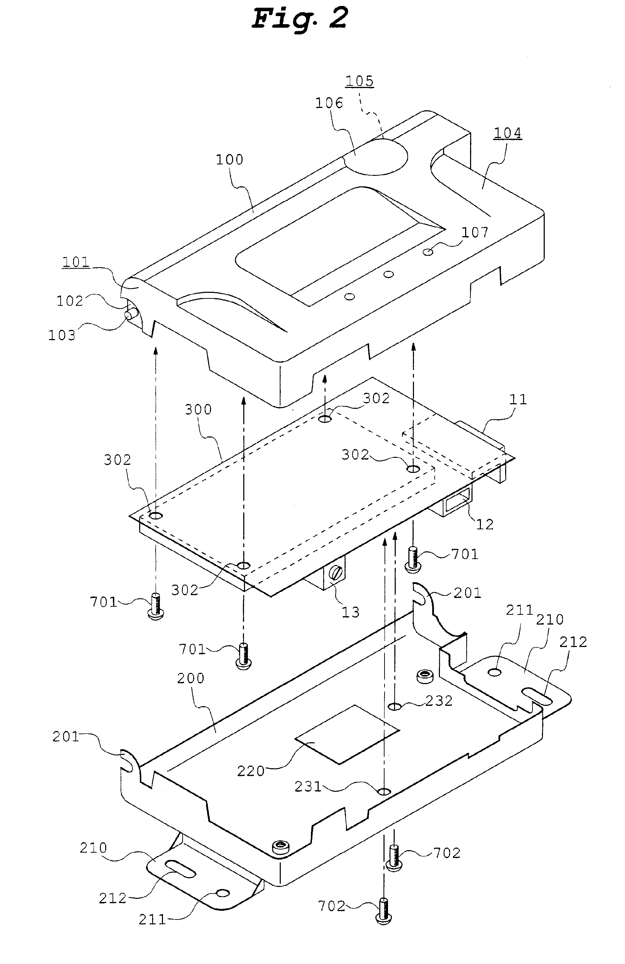

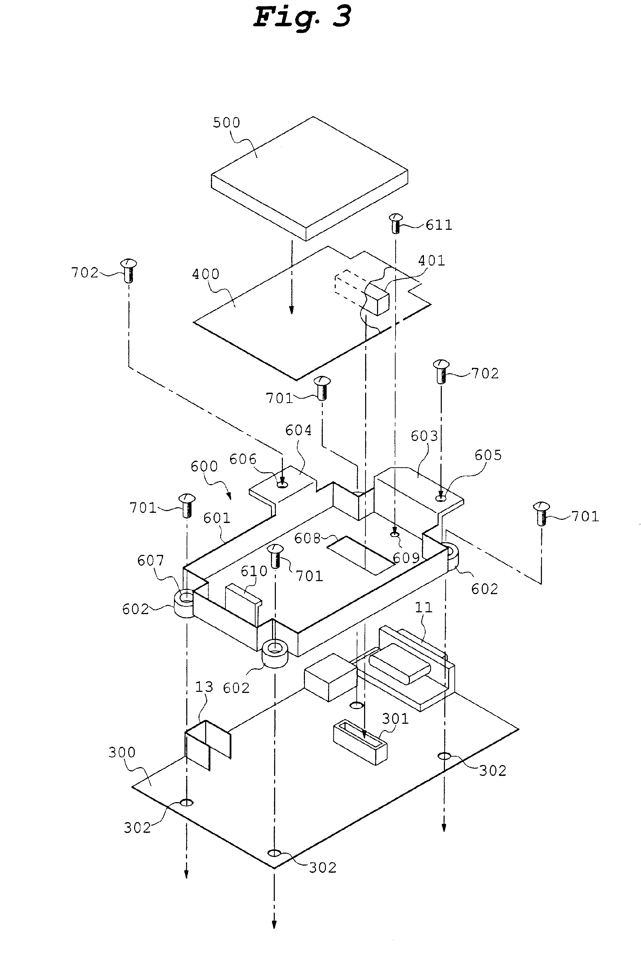

A communication device according to an embodiment of the present invention will be described with reference to the drawings. FIG. 1 is a perspective diagram of a communication device. FIG. 2 is an exploded perspective view of the communication device. FIG. 3 is an exploded perspective view showing a configuration of an inner device contained in a case.

The communication device 1 includes a case 10 approximately in a shape of box as shown in FIG. 1 and FIG. 2. The case 10 includes a resin font case 100 and a metal rear case 200 of which wider surfaces are superposed on one another. In the embodiment, aluminum is used as the material of the rear case 200. An antenna terminal (not shown) including a BNC connector and the like is provided on the side of the case 10. A connector 11 for connecting with data terminal equipment is exposed by the antenna terminal on the side of the case 10. A power source terminal 12 and a grand terminal 18 are exposed at the other side of the case 10.

The case 10 includes the front case 100 and the rear case 200 coupled by a detachable hinge structure formed on one side of them. Specifically, a concave part 102 is formed on the bottom of an end at a side 101 of the front case 100. A support shaft 103 protruded lengthwise is formed on the concave part 102. A hook shaped locking part 201 is formed on the upper edge at a side of the rear case 200. With the support shaft 103 inserted into the inner periphery of the locking part 201, the front case 100 is coupled with the rear case 200 in a rotatable manner around the support shaft 103.

A hole 105 for enabling a user to operate the inner devices is made on the side of the top 104 of the front case 100. The hole 105 is sealed with a cap 106 made from elastic materials such as rubber. Lamps 107 for indicating a state of operation and the like are arranged on the top 104 of the front case.

An attachment 210 is integrated with the case on the bottom of the rear case 200. As shown in FIG. 2, the attachment 210 is protruded lengthwise from the bottom of the rear case 200 so as to make a predetermined distance between the bottom of the rear case 200 and the attached part. The attachment 210 is hung out from the side of the rear case 200. A round hole 211 and a long hole 212 for screwing are formed on the attachment 210. As shown in FIG. 2, thermal-conductive sheet made from silicon resin and the like is applied on the bottom of the rear case 200. Through-holes 231 and 232 are formed on the rear case 200. One through-hole 231 is formed on the side opposite to the side for connecting with the front case 100 with a hinge structure.

The inner devices contained in the case 10 and structures for attaching them will be described. As shown in FIG. 2 and FIG. 3, the case 10 contains a main circuit board 300, an auxiliary circuit board 400, data circuit-terminating equipment 500 mounted on the auxiliary circuit board 400, and a board case 600 for containing the auxiliary circuit board 400.

A first interface part for connecting with the data terminal equipment and a circuit for intervening communication between the data terminal equipment and the data circuit-terminating equipment 500 are mounted on the main circuit board 300. The connector 11, the power source terminal 12, the grand terminal 13 and the like are mounted on the main circuit board 300. Further, a connector 301 for connecting to the auxiliary circuit board 400 is mounted on the main circuit board 300. A through-hole 302 for screwing the main circuit board to the front case 100 with the board case 600 is formed on the main circuit board 300.

A second interface part for connecting the data circuit-terminating equipment 500 and the main circuit board 300 is mounted on the auxiliary circuit board 400. The data circuit-terminating equipment 500 is mounted on a surface of the auxiliary circuit board 400. A connector 401 for connecting with the connector 301 of the main circuit board 300 is mounted on the other side of the auxiliary circuit board 400.

The board case 600 is an integration of a case body 601, a leg part 602, a first locking piece 603 and a second locking piece 604. The case body 601 has a shape of a thin box with the top opened. The case body 601 contains the auxiliary circuit board 400. The leg part 602 is provided on each of external four corners of the case body 601. The first locking piece 603 is hung out from a shorter side of the case body 601. The second locking piece 604 is hung out from a longer side of the case body 601. Screw holes 605 and 606 are formed on the respective locking pieces 603 and 604. A through-hole 607 is formed through the leg part 602. A through-hole 608 for the connector 401 of the auxiliary circuit board 400 to be inserted is formed through the bottom of the case body 601. A screw hole 609 for fixing the auxiliary circuit board 400 is formed on a lengthwise end of the case body 601. A locking part 610 for fixing the auxiliary circuit board 400 is erected at the other lengthwise end of the case body 601. The locking part 610 is shaped like a hook at the top to be engaged with the backside of the data circuit-terminating equipment 500 mounted on the auxiliary circuit board 400.

With such a structure, the auxiliary circuit board 400 mounted with the data circuit-terminating equipment 500 is attached to the board case 600 as the locking part 610 is engaged with the backside of the data circuit-terminating equipment 500 and the screw 611 is screwed into the screw hole 609 in a state where the connector 401 is inserted through the through-hole 608. Then, the connector 401 of the auxiliary circuit board 400 connects with the connector 301 of the main circuit board 300 as the auxiliary circuit board 400 is contained in the board case 600. As the screw 701 is inserted through the through-hole 607 of the leg parts 602 of the board case 600 and the through-hole 302 of the main circuit board 300 and the screw 701 is screwed into a screw box (not shown) formed inside the front case 100, the inner devices are integrated together and attached in the case 10. Here, the main circuit board 300 is attached to the front case 100 side and the auxiliary circuit board 400 is attached to the rear case 200. As the screws 702 are inserted through the through-holes 231 and 232 of the rear case 200 and screwed into the screw holes 605 and 606 of the locking pieces 603 and 604 of the board case 600 respectively, the front case 100 and the rear case 200 are combined. Here, the top surface of the data circuit-terminating equipment 500 on the auxiliary circuit board 400 closely contacts with the heat conductive sheet 220 of the rear case 200.

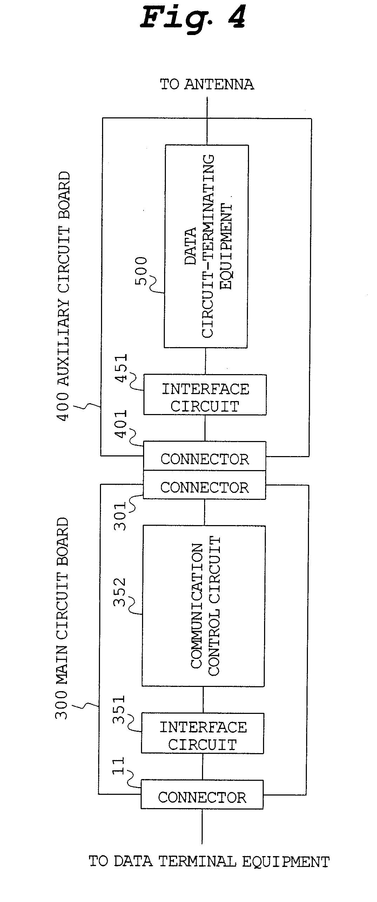

Now, each circuit board in the communication device 1 according to the embodiment and its function will be described with reference to the functional block diagram in FIG. 4.

As shown in FIG. 4, the main circuit board 300 is mounted with the connector 11 for connecting with the data terminal equipment, a first interface circuit 351 for connecting with the data terminal equipment, a data communication control circuit 352 for controlling the data communication between the data terminal equipment and the data circuit-terminating equipment 500, and the connector 301 for connecting with the auxiliary circuit board 400. The data communication control circuit 352 performs conversion, relaying and the like between the communication system of the data circuit-terminating equipment, which is a precondition of the data terminal equipment, and the communication system of the actually connected data circuit-terminating equipment 500. Specifically, the data communication control circuit 352 performs as a proxy for the connection of the network, address conversion and the like. That enables the data terminal equipment to perform communication by using the data circuit-terminating equipment 500 that has not been assumed to connect with the data terminal equipment. The data communication control circuit 352 is implemented as the FPGA (Field Programmable Gate Array), which is a kind of PLD (Programmable Logic Device) so that the data communication control circuit 352 can be easily accommodated to various kinds of data circuit-terminating equipment 500.

The auxiliary circuit board 400 is designed and manufactured to accommodate the data circuit-terminating equipment 500. The auxiliary circuit board 400 is mounted with the connector 401 for connecting with the main circuit board 300, a second interface circuit 451 for connecting with the main circuit board 300, and the data circuit-terminating equipment 500.

As the common circuit, which is independent of the data circuit-terminating equipment, is formed in the main circuit board 300, and a circuit, which depends on the data circuit-terminating equipment 500, is formed in the auxiliary circuit board 400 in the communication device 1 according to the embodiment as mentioned above, the data circuit-terminating equipment can be easily exchanged.

As the main circuit board 300 and the auxiliary circuit board 400 are superposed on one another in the communication device 1 according to the embodiment, the case 10 can be downsized. As the main circuit board 300 and the board case 600 are screwed into the front case 100 with a common screw 701, assembling can be performed easily and correctly with the reduced number of parts (the number of screws) and the less man-hour for assembling. As the auxiliary circuit board 400 is attached to the board case 600 by the screw 611 and the locking part 610, assembling can be performed easily and correctly with the reduced number of parts (the number of screws) and the less man-hour for assembling.

In the communication device 1 according to the embodiment, the heat generated at the data circuit-terminating equipment 500 is conducted to the rear case 200 via the heat conductive sheet 220. Then, the heat conducted to the rear case 200 is radiated to where the communication device 1 is mounted via the attachment 210. Here, as the rear case 200 and the attachment 210 are integrated together and the data circuit-terminating equipment 500 and the rear case 200 closely contact with each other via the heat conductive sheet 220, heat conductive loss from the rear case 200 to where the communication device 1 is mounted can be minimized. As the attachment 210 is protruded from the bottom of the rear case 200 so that the bottom of the rear case 200 does not closely contact with where the communication device 1 is mounted, a space is formed between the bottom of the rear case 200 and where the communication device 1 is mounted on. The air flowing through the space further promotes the heat radiation from the rear case 200. As the rear case 200 and the attachment 210 are integrated together, the communication device 1 has high resistance to vibration.

As the front case 100 is made from resin material and the rear case 200 is made from metal material in the communication device 1 according to the embodiment, the communication device 1 is preferable from the viewpoints of heat radiation, cost, strength and weight. That is, as the front case 100 does not need high heat radiation and strength, it is made from resin material from the viewpoints of cost and weight. On the other hand, as the rear case 200 needs high heat radiation and strength, it is made from metal material though such a material costs high and weighs heavy.

As the front case 100 and the rear case 200 are coupled with each other at one end with a detachable hinge structure and screwed with each other at the other end in the communication device 1 of the present invention, assembling can be performed easily and correctly.

Although an embodiment of the present invention has been detailed above, the present invention is not limited to that. Although the front case 100 is made from resin material and the rear case 200 is made from metal material in the abovementioned embodiment, preferable materials may be used for the material for each case in total consideration of the heat radiation, cost, strength, weight and the like as required.

## Claims

1. A communication device comprising:
a case (10) approximately in a shape of box;
data circuit-terminating equipment (DCE) (500) contained in the case (10) for connecting with a radio packet communication network; and
a circuit board provided with a circuit for connecting data terminal equipment (DTE) and said data circuit-terminating equipment (500) each other and mounted with said data circuit-terminating equipment (500);
wherein said circuit board comprises a main circuit board (300) comprising a first interface circuit (351) for connecting with data terminal equipment and a circuit (352) for intervening communication between the data terminal equipment and the data circuit-terminating equipment (500), and an auxiliary circuit board (400) comprising a second interface circuit (451) for connecting the data circuit-terminating equipment (500) and the main circuit board (300); and
said data circuit-terminating equipment (500) is mounted on the auxiliary circuit board (400).

2. The communication device according to claim 1, wherein the main circuit board (300) and the auxiliary circuit board (400) are connected with each other by coupling a connector (301) provided on the top surface of said main circuit board (300) to a connector (401) provided on the bottom of the auxiliary circuit board (400).

3. The communication device according to claim 2, comprising:
a board case (600) having a through-hole (608), through which a coupling part between the connector (301) of said main circuit board (300) and the connector (401) of the auxiliary circuit board (400) can pass, formed on the bottom, and containing said auxiliary circuit board (400).

4. The communication device according to claim 3, wherein
an end of said auxiliary circuit board (400) is locked with the locking part (610) formed on the board case (600) and the other end is screwed into the board case (600).

5. The communication device according to claim 3, wherein
said board case (600) and the main circuit board (300) are screwed into the case (10) of the communication device (1) with a common screw (701).

6. The communication device according to claim 5, wherein
the case (10) of the communication device (1) comprises a front case (100) and a rear case (200) of which wider surfaces are superposed on one another, and said main circuit board (300) and the board case (600) are screwed into the inner surface of the front case (100).

7. The communication device according to claim 6, wherein
said data circuit-terminating equipment (500) contacts with the inner surface of the rear case (200) via a heat conductive material (220).
